# EUROPÄISCHE PATENTANMELDUNG

(11) **EP 3 671 965 A1**
(43) Veröffentlichungstag der Anmeldung: **24.06.2020**
(21) Anmeldenummer: 19215472.2
(22) Anmeldetag: 12.12.2019
(51) Int. Cl.: H01R 11/28, H01R 43/16

(54) **BATTERIEPOLKLEMME, BATTERIESENSOR MIT BATTERIEPOLKLEMME UND VERFAHREN ZUR HERSTELLUNG EINER BATTERIEPOLKLEMME**

(30) Priorität: 20.12.2018 DE 102018222391
(71) Anmelder: Continental Automotive GmbH, 30165 Hannover (DE)
(72) Erfinder: Frenzel, Henryk, 60488 Frankfurt am Main (DE)

(57) **Zusammenfassung**

Die Erfindung betrifft eine Batteriepolklemme (12) zum Kontaktieren eines Batteriepols einer Fahrzeugbatterie, mit einem Ringabschnitt (18), der einen zylindrischen oder konischen Aufnahmeraum (20) für den Batteriepol in einer Umfangsrichtung (U) zumindest abschnittsweise umschließt, wobei der Ringabschnitt (18) bezüglich der Umfangsrichtung (U) eine Unterbrechung (22) mit gegenüberliegenden Rändern (24) aufweist, an der ein Spannelement (26) vorgesehen ist, das die Ränder (24) aufeinander zu bewegen kann. An einer radialen Innenseite (32) des Ringabschnitts (18) ist eine Reibstruktur (34) mit zumindest einem radial nach innen ragenden Vorsprung (36) vorgesehen.

Die Erfindung betrifft des Weiteren einen Batteriesensor (10) mit einer solchen Batteriepolklemme (12) sowie ein Verfahren zur Herstellung eines solchen Batteriepolklemme (12).

## Beschreibung

Die Erfindung betrifft eine Batteriepolklemme zum Kontaktieren eines Batteriepols einer Fahrzeugbatterie, mit einem Ringabschnitt, der einen zylindrischen oder konischen Aufnahmeraum für den Batteriepool in einer Umfangsrichtung zumindest abschnittsweise umschließt, wobei der Ringabschnitt bezüglich der Umfangsrichtung eine Unterbrechung mit gegenüberliegenden Rändern aufweist, an der ein Spannelement vorgesehen ist, das die Ränder aufeinander zu bewegen kann. Die Erfindung betrifft des Weiteren einen Batteriesensor mit einer solchen Batteriepolklemme sowie ein Verfahren zur Herstellung eines solchen Batteriepolklemme.

Mit einer solchen Batteriepolklemme wird ein Kabel oder ein Batteriesensor an einem Batteriepol eine Fahrzeugbatterie befestigt. Der Batteriepol weist eine zylindrische oder konische Form auf, auf die die Batteriepolklemme mit dem Ringabschnitt aufgeschoben wird. Anschließend wird der Durchmesser des Ringabschnitts reduziert, beispielsweise durch ein Spannelement, sodass der Ringabschnitt und somit die Batteriepolklemme auf dem Batteriepol verklemmt wird.

Über die Batteriepolklemme wird der elektrische Kontakt zwischen dem Kabel bzw. dem Batteriesensor und dem Batteriepol hergestellt. Der elektrische Kontakt zur Fahrzeugbatterie muss über die gesamte Lebenszeit des Fahrzeugs zuverlässig sichergestellt sein, insbesondere bei einem Batteriesensor, über den der Ladezustand bzw. der Gesundheitszustand der Batterie erfasst wird. Das heißt zum einen, dass die Batteriepolklemme mechanisch zuverlässig am Batteriepol befestigt sein muss. Die Batteriepolklemme soll weder in Längsrichtung des Batteriepols von diesem Abrutschen noch in Umfangsrichtung bezüglich des Batteriepols verdreht werden können. Zum anderen muss sichergestellt sein, dass ein zuverlässiger elektrischer Kontakt zwischen der Batteriepolklemme und den Batteriepol hergestellt ist.

Üblicherweise bestehen die Batteriepolklemme aus einem Schmiedeteil oder einem Stanz-Biege-Teil. Insbesondere bei geschmiedeten Batteriepolklemmen wird die Innenseite des Ringabschnitts mechanisch nachgearbeitet, beispielsweise, indem Bereiche mit unterschiedlichen Durchmessern eingefräst werden, die in einem Querschnitt eine Treppenstruktur bilden. Wird ein solcher Ringabschnitt auf den Batteriepol aufgeschoben und an diesem verklemmt, wird durch die vorstehenden Kanten dieser Treppenstruktur partiell der Druck zwischen der Batteriepolklemme und dem Batteriepol erhöht. Über die Kanten der Treppenstruktur ergibt sich eine höhere Reibung zwischen der Batteriepolklemme und den Batteriepol, sodass ein verbesserter mechanischer Halt sichergestellt ist. Allerdings wird bei dieser Ausführungsform die Gesamtfläche zwischen der Batteriepolklemme und dem Batteriepol, die für einen Stromfluss zur Verfügung steht, verringert. Zudem ist das Einbringen eine solchen Struktur sehr aufwendig.

Alternativ wird versucht, Aussparungen in den Ringabschnitt einzufräsen oder beim Stanz-Biegen einzubringen, wobei sich beim Verklemmen der Batteriepolklemme auf den Batteriepol das im Vergleich zum Material der Batteriepolklemme weichere Material des Batteriepols in diese Aussparungen hineinformen soll. Hierbei wird aber nicht die gewünschte mechanische Stabilität erreicht.

Aufgabe der Erfindung ist es, eine Batteriepolklemme sowie einen Batteriesensor mit einer solchen Batteriepolklemme bereitzustellen, die einen zuverlässigen mechanischen Halt sowie eine zuverlässige elektrische Kontaktierung an einem Batteriepol ermöglichen. Aufgabe der Erfindung ist es des Weiteren, ein Verfahren zur Herstellung einer solchen Batteriepolklemme bereitzustellen.

Zur Lösung der Aufgabe ist bei einer Batteriepolklemme zum Kontaktieren eines Batteriepols einer Fahrzeugbatterie, mit einem Ringabschnitt, der einen zylindrischen oder konischen Aufnahmeraum für den Batteriepool in einer Umfangsrichtung zumindest abschnittsweise umschließt, wobei der Ringabschnitt bezüglich der Umfangsrichtung eine Unterbrechung mit gegenüberliegenden Rändern aufweist, an der ein Spannelement vorgesehen ist, das die Ränder aufeinander zu bewegen kann, vorgesehen, dass an einer radialen Innenseite des Ringabschnitts eine Reibstruktur mit zumindest einem radial nach innen ragenden Vorsprung vorgesehen ist.

Vorzugsweise weisen die Vorsprünge nur eine so geringe Höhe auf, so dass sich die Vorsprünge beim Verklemmen der Batteriepolklemme auf dem Batteriepol in das weichere Material des Batteriepols soweit eindrücken, dass die Innenseite des Ringabschnitts flächig am Batteriepol anliegt, wobei durch die Vorsprünge keine bleibende oder nur eine geringe Verformung des Batteriepols erfolgt. Da die gesamte Innenseite des Ringabschnitts am Batteriepol anliegt, steht eine ausreichend große Fläche für den Stromfluss zwischen dem Batteriepol und der Batteriepolklemme zur Verfügung. Durch die Reibstruktur ist ein zuverlässiger mechanischer Halt der Batteriepolklemme am Batteriepol sichergestellt. Die Vorsprünge werden beispielsweise durch eine Prägung bei der Herstellung der Batteriepolklemme auf der Innenseite des Ringabschnitts aufgebracht.

Vorzugsweise beträgt die radiale Höhe des zumindest einen Vorsprung zwischen 0,02 und 0,3 mm, vorzugsweise zwischen 0,03 und 0,2 mm beträgt. Diese Höhe ist ausreichend, um eine mechanische Fixierung zwischen der Batteriepolklemme und dem Batteriepol zu erzielen, wenn sich die Vorsprünge in das Material des Batteriepols eindrücken. Andererseits sind die Vorsprünge nicht so hoch bzw. so groß, dass diese am Batteriepol bleibende Verformungen oder Beschädigungen hinterlassen, sodass die Batterieklemme entfernt und anschließend auch in einer anderen Position oder einer anderen Orientierung befestigt werden kann, ohne dass die Vorsprünge an vorher eingebrachten Vertiefungen am Batteriepol verrasten oder verklemmen.

Die Reibstruktur weist vorzugsweise mehrere in Längsrichtung und/oder in Umfangsrichtung verteilt angeordnete Vorsprünge auf, wobei die Vorsprünge so angeordnet sind, dass sowohl in Umfangsrichtung wie auch in Längsrichtung des Batteriepols eine zuverlässige mechanische Fixierung der Batteriepolklemme sichergestellt ist.

Beispielsweise erstreckt sich zumindest ein Vorsprung in Umfangsrichtung und/oder zumindest ein Vorsprung in Längsrichtung des Aufnahmeraums, so dass eine zuverlässige mechanische Fixierung sowohl in Längsrichtung wie auch in Umfangsrichtung des Aufnahmeraums gewährleistet ist.

Der Abstand von in Umfangsrichtung und/oder in Längsrichtung benachbarter Vorsprünge ist vorzugsweise wesentlich größer ist als die Länge der Vorsprünge in Umfangsrichtung und/oder in Längsrichtung, sodass auch, wenn die Vorsprünge Abdrücke in der Oberfläche des Batteriepols hinterlassen sollten, eine erneute Montage der Batteriepolklemme möglich ist, ohne dass die Vorsprünge in am Batteriepol vorhandene Abdrücke eintauchen oder an diesen verrasten. Die Freiräume zwischen benachbarten Vorsprünge sind vorzugsweise wesentlich größer als die Dimensionierung der Vorsprünge.

Die Reibstruktur kann sich des Weiteren in Umfangsrichtung und/oder in Längsrichtung des Aufnahmeraums nur über einen Teilbereich der Innenseite des Ringabschnitts erstreckt.

Die Vorsprünge können zumindest teilweise mit einem Stanz-Biege-Verfahren hergestellt sein. Beispielsweise wird die Batteriepolklemme mit einem Stanz-Biege-Verfahren hergestellt, wobei die Vorsprünge bereits mit dem Prozess auf der Innenseite des Ringabschnitts eingeprägt werden, um zusätzliche Arbeitsschritte zu vermeiden.

Alternativ kann der Ringabschnitt auch gestanzte Durchbrüche aufweist, wobei die Vorsprünge durch teilweise radial nach innen ragende Stanzgrate der Durchbrüche gebildet sind.

Da die Reibstruktur bzw. die Vorsprünge bei der Herstellung der Batteriepolklemme hergestellt werden können und keine zusätzlichen Arbeitsschritte erforderlich sind, ist eine kostengünstige Herstellung der Batteriepolklemme möglich.

Zur Lösung der Aufgabe ist des Weiteren ein Batteriesensor mit einer vorstehend beschriebenen Batteriepolklemme und einem Kabelanschluss vorgesehen, wobei der Batteriesensor des Weiteren zumindest eine Messeinrichtung zur Erfassung eines zwischen der Batteriepolklemme und dem Kabelanschluss fließenden Stroms oder eines Spannungsabfalls zwischen der Batteriepolklemme und dem Kabelanschluss aufweist.

Des Weiteren ist zur Lösung der Aufgabe ein Verfahren zur Herstellung einer vorstehend beschriebenen Batteriepolklemme vorgesehen, wobei der Ringabschnitt mit einem Stanzbiegeverfahren und/oder mit einem Stanzverfahren hergestellt wird.

Weitere Vorteile Merkmale ergeben sich aus der nachfolgenden Beschreibung in Verbindung mit den beigefügten Zeichnungen. In diesen zeigen:
- Figur 1: einen Batteriesensor mit einer erfindungsgemäßen Batteriepolklemme;
- Figur 2: eine Schnittansicht durch die Batteriepolklemme des Batteriesensors aus Figur 1;
- Figur 3: eine Detailansicht der Batteriepolklemme aus Figur 2;
- Figur 4: eine Schnittansicht durch eine zweite Ausführungsform einer erfindungsgemäßen Batteriepolklemme;
- Figur 5: eine schematische Darstellung einer dritten Ausführungsform einer erfindungsgemäßen Batteriepolklemme; und
- Figur 6: eine schematische Darstellung einer vierten Ausführungsform einer erfindungsgemäßen Batteriepolklemme.

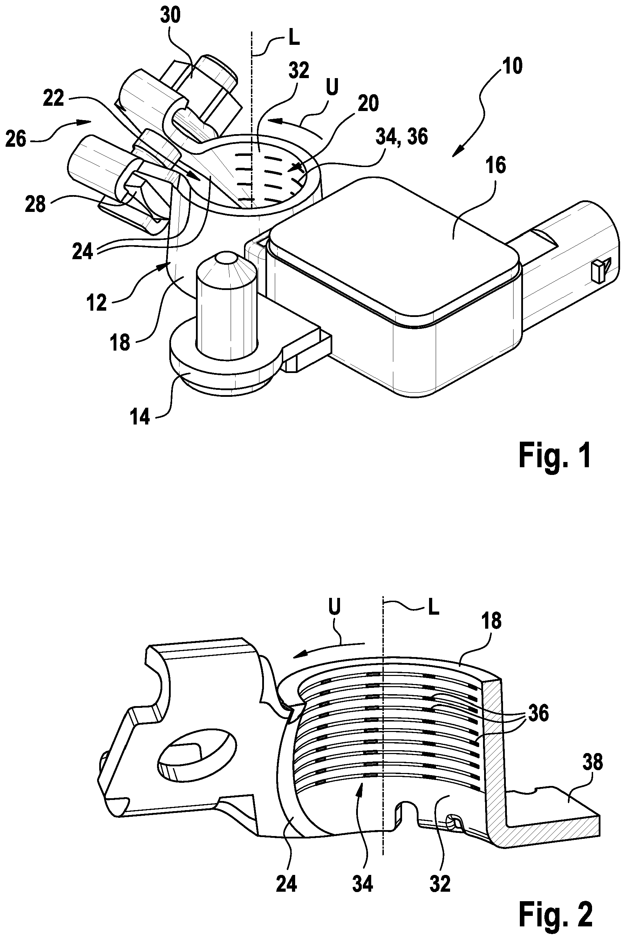

In Figur 1 ist ein Batteriesensor 10 zur Erfassung verschiedener Batteriewerte, beispielsweise der Batteriespannung, des Batteriestroms und/oder der Batterietemperatur gezeigt. Aus den mit dem Batteriesensor 10 ermittelten Batteriewerten können Aussagen über den Zustand der Fahrzeugbatterie, insbesondere den Ladezustand der Fahrzeugbatterie ermittelt werden.

Der Batteriesensor 10 hat eine Batteriepolklemme 12, eine Kabelanschluss 14 sowie eine zwischen der Batteriepolklemme 12 und dem Kabelanschluss 14 angeordnete Messeinrichtung 16 zur Erfassung der Batteriewerten. Beispielsweise weist die Messeinrichtung einen zwischen der Batteriepolklemme 12 und dem Kabelanschluss 14 angeordnete Messwiderstand sowie eine Erfassungseinrichtung für einen Spannungsabfall über den Messwiderstand auf.

Die Batteriepolklemme 12 weist einen Ringabschnitt 18 auf, der einen im Wesentlichen zumindest abschnittsweise zylindrischen oder konischen Aufnahmeraum 20 in Umfangsrichtung U zumindest abschnittsweise umschließt. Der Ringabschnitt 18 weist bezüglich der Umfangsrichtung eine schräg in Richtung der Längsachse L des Aufnahmeraums 20 verlaufende Unterbrechung 22 mit gegenüberliegenden Rändern 24 auf. An den gegenüberliegenden Rändern ist ein Spannelement 26, das in der hier gezeigten Ausführungsform durch eine Schraube 28 und eine Mutter 30 gebildet ist, vorgesehen, mit dem die Ränder 24 aufeinander zu gedrängt werden können, wodurch der Durchmesser der Aufnahme 20 reduziert wird. Am Ringabschnitt 18 ist des Weiteren ein Stromabgang 38 vorgesehen, der beispielsweise mit der Messeinrichtung oder einem Messwiderstand kontaktiert ist.

Zur Montage der Batteriepolklemme 12 wird der Ringabschnitt 18 auf einen im Wesentlichen zylindrischen und/oder konischen Batteriepol aufgeschoben wobei der Innendurchmesser des Aufnahmeraums 20 größer ist als der Durchmesser des Batteriepols. Anschließend wird der Durchmesser des Ringabschnitts 18 mit dem Spannelement 26 derart reduziert, dass der Batteriepol flächig auf der Innenseite 32 des Ringabschnitts 18 anliegt. Durch eine ausreichend hohe Spannung des Spannelements 26 wird eine Bewegung der Batteriepolklemme 12 sowohl in Umfangsrichtung U wie auch in Richtung der Längsachse L zuverlässig verhindert. Durch das flächige Anliegen am Batteriepol ist des Weiteren eine zuverlässige Kontaktierung mit einer ausreichend hohen Kontaktfläche zwischen dem Batteriepol und der Batteriepolklemme 12 sichergestellt.

Wie in Figur 2 zu sehen ist, ist auf der Innenseite 32 eine Reibstruktur 34 vorgesehen, die mehrere in Umfangsrichtung und in Richtung der Längsachse L gleichmäßig verteilt angeordneten Vorsprüngen 36 aufweist. In der hier gezeigten Ausführungsform erstrecken sich die Vorsprünge 36 in Umfangsrichtung U, wobei der Abstand von in Umfangsrichtung U benachbarten Vorsprüngen 36 wesentlich größer ist als die Länge der Vorsprünge 36 in Umfangsrichtung U. Die Vorsprünge 36 sind des Weiteren auf mehreren in Richtung der Längsachse L gleichmäßig verteilt angeordneten Ebenen angeordnet, wobei die Vorsprünge 36 in Längsrichtung 36 jeweils hintereinander angeordnet sind.

Die Höhe der Vorsprünge 36 beträgt zwischen 0,02 und 0,3 mm, vorzugsweise zwischen 0,03 und 0,2 mm.

Beispielsweise wird die Batteriepolklemme 12 mit einem Stanz-Biege-Verfahren hergestellt und die Vorsprünge sind bei der Herstellung der Batteriepolklemme 12 mit dem Stanz-Biege-Prozess auf der Innenseite 32 des Ringabschnitts 18 aufgebracht. Alternativ können diese auch durch einen nachfolgenden Prägeprozess aufgebracht werden.

Die Batteriepolklemme 12, insbesondere der Ringabschnitt 18, ist aus einem härteren Material hergestellt als der Batteriepol. Üblicherweise wird die Batteriepolklemme 12 aus Kupfer bzw. einer Kupferlegierung hergestellt. Der Batteriepol besteht aus Blei oder einer Bleilegierung.

Bei der Montage der Batteriepolklemme 12, insbesondere beim Spannen des Spannelements 26 drücken sich die Vorsprünge 36 in das weichere Material des Batteriepols ein, sodass sowohl in Umfangsrichtung U wir auch in Richtung der Längsachse L ein Formschluss gebildet wird, durch den eine zuverlässige mechanische Fixierung sowohl in Umfangsrichtung U wir auch in Richtung der Längsachse L sichergestellt ist. Die Höhe der Vorsprünge 36 ist derart gewählt, dass die Vorsprünge 36 keine bleibende Verformung des Batteriepols hervorrufen. Insbesondere erfolgt beispielsweise keine oder nur eine geringe plastische Verformung des Batteriepols. Dadurch ist ein Lösen der Batteriepolklemme 12 und eine nachfolgende Montage in einer anderen Orientierung möglich, ohne dass die Vorsprünge 36 in bereits vorhandenen Verformungen oder Vertiefungen verrasten.

Durch die geringe Höhe der Vorsprünge 36 drücken sich die Vorsprünge im Wesentlichen vollständig in das Material des Batteriepols ein, sodass die Innenseite 32 des Ringabschnitts 18 flächig mit dem Batteriepol in Anlage gelangt. Dadurch ist ein flächiger elektrischer Kontakt zwischen dem Batteriepol und der Batteriepolklemme 12 hergestellt, sodass eine ausreichend große Fläche für den Stromfluss zur Verfügung steht.

Die Anzahl, die Form, die Position sowie die Anordnung der Vorsprünge 36 der Reibstruktur 34 kann beliebig an die gewünschte mechanische Stabilität bzw. die gewünschten Haltekräfte angepasst werden. Insbesondere können die Vorsprünge in Umfangsrichtung U und/oder in Richtung der Längsachse L des Aufnahmeraums 20 beliebig verteilt werden. Des Weiteren kann auch die Orientierung der Vorsprünge 36 beliebig angepasst werden, wobei die Vorsprünge 36 vorzugsweise so angeordnet sind, dass diese sowohl Kräfte in Umfangsrichtung U wie auch in Richtung der Längsachse L aufnehmen können. Die Vorsprünge 36 können auch unterschiedliche Orientierungen aufweisen.

Des Weiteren können auch Vertiefungen an der Innenseite 32 des Ringabschnitts 18 vorgesehen sein, in die beispielsweise Verschmutzungen oder Anhaftungen am Batteriepol hineingedrängt werden können.

Vorzugsweise ist der Abstand benachbarter Vorsprünge 36 so groß, dass zwischen den Vorsprüngen eine ausreichend große Fläche zur Verfügung steht, die mit dem Batteriepol in Anlage gelangen kann. Der Abstand benachbarter Vorsprünge 36 ist daher vorzugsweise wesentlich größer als deren Ausdehnung.

Die Reibstruktur 34 kann sich in Umfangsrichtung Q und/oder in Richtung der Längsachse L auch nur über einen Teilbereich der Innenseite 32 des Ringabschnitts 18 erstrecken.

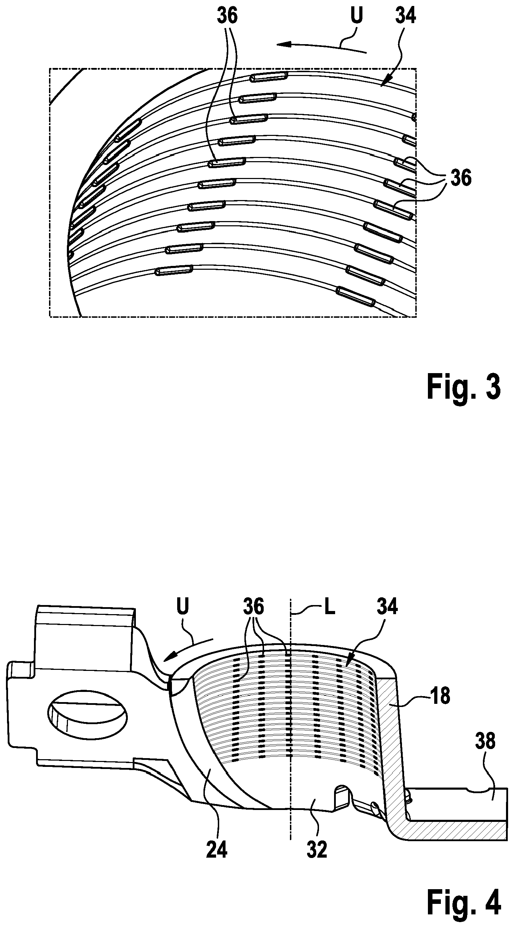

In Figur 4 ist eine Reibstruktur 34 gezeigt, die im Wesentlichen der in Figur zwei gezeigten Reibstruktur 34 entspricht. Die Vorsprünge 36 weisen aber in Umfangsrichtung U eine geringere Länge, einen geringeren Abstand untereinander sowie eine geringere radiale Höhe auf. Des Weiteren ist der Abstand in Richtung der Längsachse L geringer.

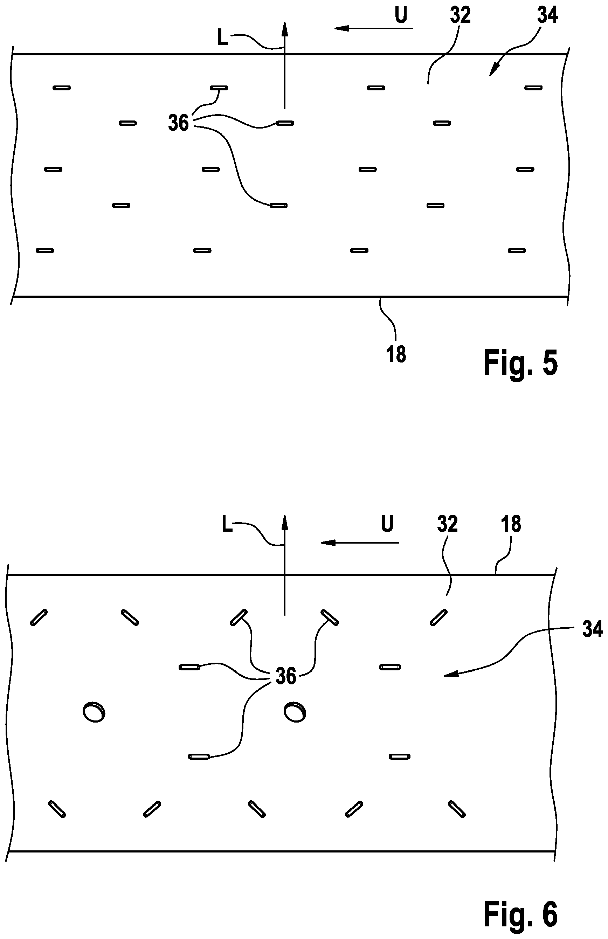

In Figur 5 sind die Vorsprünge 36 jeweils bezüglich der Umfangsrichtung U und in Richtung der Längsachse L versetzt angeordnet, sodass die Abstände zwischen den einzelnen Vorsprüngen 36 größer sind.

In Figur 6 weisen die Vorsprünge 36 verschiedene Orientierungen auf, wobei die Orientierung teilweise in Richtung der Umfangsrichtung U verläuft und teilweise schräg zu Umfangsrichtung U und zur Richtung der Längsachse L.

In den vorstehend beschriebenen Ausführungsformen sind die Vorsprünge jeweils lediglich auf der Innenseite 32 Ringabschnitts 18 ausgebildet und nicht von der Außenseite sichtbar.

Alternativ ist auch denkbar, dass die Reibstruktur 34, insbesondere die Vorsprünge 36, von der Außenseite radial nach innen eingeprägt sind, sodass die Außenseite des Ringabschnitts 18 Vertiefungen aufweist.

Es können auch Aussparungen in den Ringabschnitt 18 eingebracht werden, beispielsweise durch Stanzen, wobei die Vorsprünge 36 durch die Stanzgrate gebildet sein können. Da die Aussparungen ein geringerer Querschnitt für den Stromfluss zur Verfügung steht, werden die Aussparungen vorzugsweise bezüglich der Umfangsrichtung U entgegengesetzt zu einem Stromabgang 38 der Batteriepolklemme 12 angeordnet.

Die Vorsprünge 36 können aber auch durch andere Oberflächenbearbeitungsverfahren hergestellt werden.

### Bezugszeichenliste

- 10: Batteriesensor
- 12: Batteriepolklemme
- 14: Kabelanschluss
- 16: Messeinrichtung
- 18: Ringabschnitt
- 20: Aufnahmeraum
- 22: Unterbrechung
- 24: Ränder der Unterbrechung
- 26: Spannelement
- 28: Schraube
- 30: Mutter
- 32: Innenseite des Ringabschnitts
- 34: Reibstruktur
- 36: Vorsprung
- 38: Stromabgang

- L: Längsachse
- U: Umfangsrichtung

## Patentansprüche

1. Batteriepolklemme (12) zum Kontaktieren eines Batteriepols einer Fahrzeugbatterie, mit einem Ringabschnitt (18), der einen zylindrischen oder konischen Aufnahmeraum (20) für den Batteriepol in einer Umfangsrichtung (U) zumindest abschnittsweise umschließt, wobei der Ringabschnitt (18) bezüglich der Umfangsrichtung (U) eine Unterbrechung (22) mit gegenüberliegenden Rändern (24) aufweist, an der ein Spannelement (26) vorgesehen ist, das die Ränder (24) aufeinander zu bewegen kann,
**dadurch gekennzeichnet, dass**
an einer radialen Innenseite (32) des Ringabschnitts (18) eine Reibstruktur (34) mit zumindest einem radial nach innen ragenden Vorsprung (36) vorgesehen ist.

2. Batteriepolklemme nach Anspruch 1, **dadurch gekennzeichnet, dass** die Reibstruktur (34) mehrere in Richtung der Längsachse (L) und/oder in Umfangsrichtung (U) des Aufnahmeraums (20) verteilt angeordnete Vorsprünge (34) aufweist.

3. Batteriepolklemme nach Anspruch 2, **dadurch gekennzeichnet, dass** sich zumindest ein Vorsprung (34) in Umfangsrichtung (U) und/oder zumindest ein Vorsprung (34) in Richtung der Längsachse (L) des Aufnahmeraums (20) erstreckt.

4. Batteriepolklemme nach einem der Ansprüche 2 und 3, **dadurch gekennzeichnet, dass** der Abstand von in Umfangsrichtung (U) und/oder in Richtung der Längsachse (L) benachbarter Vorsprünge (34) wesentlich größer ist als die Länge der Vorsprünge (34) in Umfangsrichtung (U) und/oder in Richtung der Längsachse (L).

5. Batteriepolklemme nach einem der vorhergehenden Ansprüche, **dadurch gekennzeichnet, dass** sich die Reibstruktur (34) in Umfangsrichtung (U) und/oder in Richtung der Längsachse (L) des Aufnahmeraums (20) nur über einen Teilbereich der Innenseite (32) des Ringabschnitts (18) erstreckt.

6. Batteriepolklemme nach einem der vorhergehenden Ansprüche, **dadurch gekennzeichnet, dass** die radiale Höhe des zumindest einen Vorsprung (34) zwischen 0,02 und 0,3 mm, vorzugsweise zwischen 0,03 und 0,2 mm, beträgt.

7. Batteriepolklemme nach einem der vorhergehenden Ansprüche, **dadurch gekennzeichnet, dass** die Vorsprünge (34) zumindest teilweise mit einem Stanz-Biege-Verfahren hergestellt sind.

8. Batteriepolklemme nach einem der vorhergehenden Ansprüche, **dadurch gekennzeichnet, dass** der Ringabschnitt (18) gestanzte Durchbrüche aufweist, wobei die Vorsprünge (34) durch teilweise radial nach innen ragende Stanzgrate der Durchbrüche gebildet sind.

9. Batteriesensor (10) mit einer Batteriepolklemme (12) nach einem der vorhergehenden Ansprüche, mit einem Kabelanschluss (14) und mit einer Messeinrichtung (16) zur Erfassung eines zwischen der Batteriepolklemme (12) und dem Kabelanschluss (14) fließenden Stroms oder eines Spannungsabfalls zwischen der Batteriepolklemme (12) und dem Kabelanschluss (14) aufweist.

10. Verfahren zur Herstellung einer Batteriepolklemme (12) nach einem der vorhergehenden Ansprüche, **dadurch gekennzeichnet, dass** der Ringabschnitt (18) mit einem Stanzbiegeverfahren und/oder mit einem Stanzverfahren hergestellt ist.
